(19) Europäisches Patentamt
European Patent Office
Office européen des brevets

(11) Publication number: **0 451 857 A2**

(12) **EUROPEAN PATENT APPLICATION**

(21) Application number: **91105834.5**

(51) Int. Cl.[5]: **H01P 5/02**

(22) Date of filing: **12.04.91**

(30) Priority: **13.04.90 JP 98381/90**

(43) Date of publication of application:
**16.10.91 Bulletin 91/42**

(84) Designated Contracting States:
**DE FR GB NL SE**

(71) Applicant: **SUMITOMO ELECTRIC INDUSTRIES, LTD.**
**5-33, Kitahama 4-chome, Chuo-ku**
**Osaka-shi, Osaka 541(JP)**

(72) Inventor: **Shiga, Nobuo, c/o Yokohama Works**
**Sumitomo Electric Ind. Ltd., 1, Taya-cho, Sakae-ku**
**Yokohama-shi, Kanagawa(JP)**

(74) Representative: **Lehn, Werner, Dipl.-Ing. et al**
**Hoffmann, Eitle & Partner Patentanwälte**
**Arabellastrasse 4**
**W-8000 München 81(DE)**

(54) **Input matching circuit.**

(57) In an input matching circuit adapted to be connected to an input circuit of a low noise amplifier, a matching point of impedance conversion is set to a point shifted from a mean value of variations of an optimum signal source impedance of the low noise amplifier so that a change of noise index is gentle even if the optimum signal source impedance of the low noise amplifier includes variations.

Fig. 1

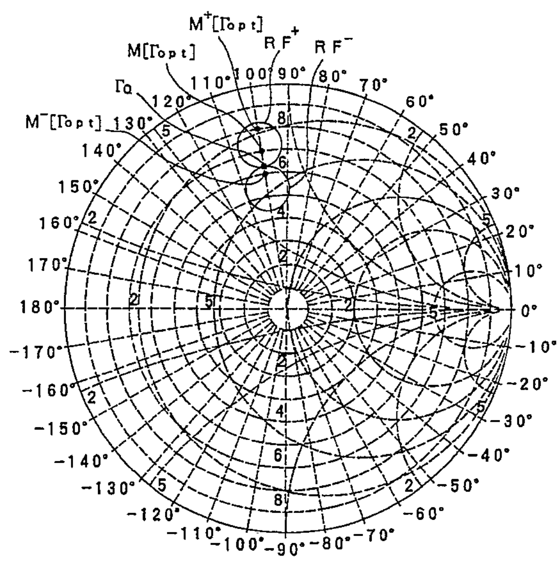


EP 0 451 857 A2

## BACKGROUND OF THE INVENTION

(Field of the Invention)

The present invention related to an input matching circuit connected to an input circuit of a low noise amplifier which is used in a converter for direct broadcast satellite (DBS) systems.

(Related Background Art)

A noise figure (NF) of an amplifier which uses a field effect transistor (FET) varies with a signal source impedance viewed from the FET toward a signal source, and it is minimum at certain signal source impedance ($Z_{opt}$). Thus, an input matching circuit is provided in the signal source of FET so that the signal source impedance viewed from the FET assumes an optimum signal source impedance $Z_{opt}$.

However, the optimum signal source impedance $Z_{opt}$ varies with variation in the manufacture of the FET. A prior art input matching circuit of the low noise amplifier has been designed such that the signal source impedance viewed from the FET is a mean value of the variations of the optimum signal source impedance $Z_{opt}$.

However, a constant noise contour on a Smith chart for FET 1 is not symmetric to the optimum signal source impedance $Z_{opt}$ but it is offset. As a result, even if an external impedance (50Ω) is converted to the meanvalue of the optimum signal source impedance $Z_{opt}$, a meanvalue of variations of the NF of the amplifier is not necessarily minimum due to the offset of the constant noise contour.

## SUMMARY OF THE INVENTION

It is an object of the invention to resolve the above problem. In accordance with the present invention, the input matching circuit adapted to be connected to an input circuit of an amplifier is characterized by that a line connecting a point on a Smith chart indicating a mean value of variations of an optimum signal source impedance due to manufacture variations of the amplifier and a center point of the Smith chart is drawn, two points on the line which are spaced from the mean value point by predetermined multiples of a standard deviation of variations of said optimum signal source impedance are determined, a crosspoint of those constant noise contours in two groups of constant noise contours respectively having the two points as the optimum signal source impedances and imparting the same noise figure on the line is determined, and the signal source impedance as viewed from said low noise amplifier is designed to have the impedance indicated by said crosspoint. The matching point thus determined is located such that an interval between the constant noise contour is larger than that where the meanvalue of the variations of the optimum signal source impedance of the amplifier to be connected is used as the matching point. Accordingly, even if the optimum signal source impedance varies, the change of the noise index is gentle and the mean value of the manufacturing variations of the NF of the low noise amplifier is smaller.

The present invention will become more fully understood from the detailed description given hereinbelow and the accompanying drawings which are given by way of illustration only, and thus are not to be considered as limiting the present invention.

Further scope of applicability of the present invention will become apparent from the detailed description given hereinafter. However, it should be understood that the detailed description and specific examples, while indicating preferred embodiments of the invention, are given by way of illustration only, since various changes and modifications within the spirit and scope of the invention will become apparent to those skilled in the art from this detailed description.

## BRIEF DESCRIPTION OF THE DRAWINGS

Fig.1 shows a Smith chart for illustrating setting of a matching point in a low noise amplifier in one embodiment of the present invention,

Fig.2 shows a smith chart for illustrating a locus of constant noise figures,

Fig.3 shows a Smith chart for explaining magnitude of interval of constant noise contours,

Fig.4 shows a Smith chart for explaining a difference between variations of noise indices due to difference in positions of matching points for impedance conversion,

Fig.5 shows a configuration of a amplifier of the embodiment,

Fig.6 shows a Smith chart for explaining a shift status of matching point in the amplifier shown in Fig. 5, and

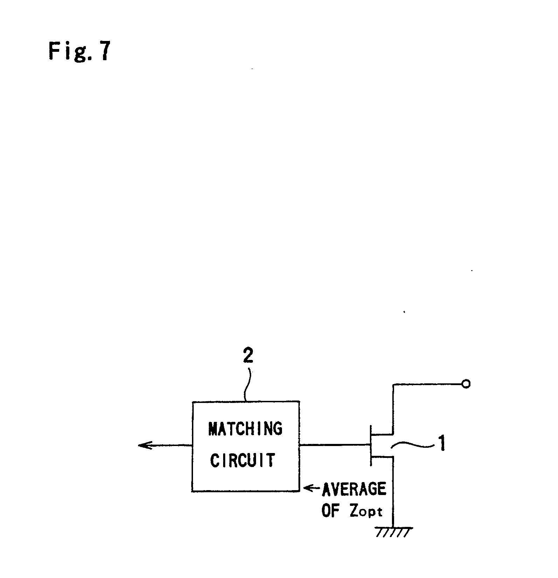

Fig. 7 shows a prior art amplifier.

## DETAILED DESCRIPTION OF THE PREFERRED EMBODIMENTS

In general, the NF (herein after F) of the FET is represented by

$$F = F_{min} + (4R_n|\Gamma_s - \Gamma_{opt}|^2) / \{(1-[\Gamma_s|^2)|1 + \Gamma_{opt}|^2\}$$

where

$F_{min}$ is a minimum value of NF,

$R_n$ is equivalent noise resistance
$\Gamma_s$ is a signal source power reflection coefficient
$\Gamma_{opt}$ is optimum signal source power reflection coefficient which minimizes NF
$\Gamma_{opt}$ and $Z_{opt}$ have a relationship of

$$\Gamma_{opt} = \frac{Z_{opt} - 50}{Z_{opt} + 50}$$

$\Gamma_{opt}$ and $Z_{opt}$ indicate the same point on a Smith chart.

There are infinite number of combinations of signal source power reflection coefficient $\Gamma_s$ in which F (excluding $F_{min}$) assumes a constant value, and a locus thereof is a circle on a smith chart shown in Fig.2. This circle is called a constant noise contour, and a center ($C_{Fi}$ and a radius $R_{Fi}$ of the constant noise contour for a noise index $F_i$ are given by

$C_{Fi} = \Gamma_{opt} / (1 + N_i)$
$R_{Fi} = \{1 / (1 + N_i)\} \cdot \{N_i^2 + Ni\ (1 - |\Gamma_{opt}|^2)\}^{1/2}$
Where $Ni = \{(F_i - F_{min})/4R_n\} \cdot |1 + \Gamma_{opt}|^2$

As seen from the above equation, the center $C_{Fi}$ of the constant noise contour is on the vector $\Gamma_{opt}$ and the respective circles are not concentric. As a result, the interval of the constant noise contour is smallest toward the vector $\Gamma_{opt}$ starting from $\Gamma_{opt}$, and largest toward the vector $-\Gamma_{opt}$ . The mean value of variations of $\Gamma_{opt}$ is represented by M-$[\Gamma_{opt}]$as shown in Fig.3. The variation when $\Gamma_{opt}$ changes toward the vector $M[\Gamma_{opt}]$ relative to M-$[\Gamma_{opt}]$ and the variation when $\Gamma_{opt}$ changes toward the vector $-M[\Gamma_{opt}]$ are equal in the distance, but the change in the NF is largest when $\Gamma_{opt}$ changes toward the vector $M[\Gamma_{opt}]$ because the interval of the constant noise contours increases to the largest along the vector $M[\Gamma_{opt}]$. On the other hand, when $\Gamma_{opt}$ changes toward the vector $-M[\Gamma_{opt}]$, the interval of the constant noise contours changes to the smallest along the vector so that the change in the $N_F$ is small, which is a desirable condition.

Accordingly, if the input matching circuit is matched, not to $M[\Gamma_{opt}]$ but to a point slightly shifted from $M[\Gamma_{opt}]$ toward the vector $-M[\Gamma_{opt}]$, the mean value of the manufacture variations of the NF of the low noise amplifier can be reduced. For example, it is assumed that the input matching circuit is matched to a point $\Gamma_Q$ shown in Fig.4. $M^+$-$[\Gamma_{opt}]$ represents a point assumed when $\Gamma_{opt}$ is shifted from $M[\Gamma_{opt}]$ by a predetermined amount toward the vector $M[\Gamma_{opt}]$, and $M^-[\Gamma_{opt}]$ represents a point assumed when $\Gamma_{opt}$ is shifted from $M[\Gamma_{opt}]$ by the same amount toward the vector $-M[\Gamma_{opt}]$. Three constant noise contours are drawn for each of the points $M^+[\Gamma_{opt}]$ and $M^-[\Gamma_{opt}]$. The circles correspond to $F_{min}+1dB$, $F_{min}+2dB$ and $F_{min}+3dB$.

If the input matching circuit of the amplifier is designed to match to $M[\Gamma_{opt}]$, the NF of the amplifier is deteriorated by 1dB when $\Gamma_{opt}$ is shifted to $M^+[\Gamma_{opt}]$, and deteriorated by 3dB when $\Gamma_{opt}$ is shifted to $M^-[\Gamma_{opt}]$. The amounts of shift of $\Gamma_{opt}$ in the respective directions are equal and represented by

$$|M^+[\Gamma_{opt}]-M[\Gamma_{opt}]| = |M^-[\Gamma_{opt}]-M[\Gamma_{opt}]|$$

However, although the amounts of shift are equal, the degree of deterioration of the NF differs depending on the direction of shift of $\Gamma_{opt}$.

On the other hand, if the input matching circuit of the amplifier is designed to match to the point $\Gamma_Q$ shown in Fig.3, the NF of the amplifier is $F_{min}$ + 1.5dB when $\Gamma_{opt}$ of the FET is shifted to either $M^+$-$[\Gamma_{opt}]$ or $M^-[\Gamma_{opt}]$, and the meanvalue of the manufacture variations of the NF of the amplifier is reduced. A statistical property of the manufacture variations of $\Gamma_{opt}$ greatly depends on a device structure, a device size and a manufacturing process and an optimum value of $\Gamma_Q$ cannot be generally defined.

However, as for the constant noise contour when $\Gamma_{opt} = M^+[\Gamma_{opt}]$ and the constant noise contours when $\Gamma_{opt} = M^-[\Gamma_{opt}]$, there is one NF value at which the constant noise contours which impart the same NF value cross a line connecting $M[\Gamma_{opt}]$ and a center of a Smith chart. In the above example, that value is $F_{min}$ + 1.5dB. Thus it is optimum to set $\Gamma_Q$ around the crosspoint in order to minimize the mean value of the variations of the NF. However, to determine the ranges of $M^+[\Gamma_{opt}]$ and $M^-[\Gamma_{opt}]$ relative to the variations of $\Gamma_{opt}$, statistical data of the manufacture variations of $\Gamma_{opt}$ is necessary. In general, it may be set to $\pm\sigma$ $\pm 3\sigma$ (when $\sigma$ is a standard deviation of manufacture variations of $\Gamma_{opt}$).

The above discussion is explained by specific examples.

It is assumed that the mean value $M[\Gamma_{opt}]$ of the manufacture variations of $\Gamma_{opt}$ is (0.7, 100°), that is,

$|M[\Gamma_{opt}]| = 0.7$
angle $M[\Gamma_{opt}] = 100°$

and the standard deviation $\sigma$ of $|\Gamma_{opt}|$ is 0.05. |M-$[\Gamma_{opt}]$| represents the mean value of variations of the absolute value of $\Gamma_{opt}$, and angle $M[\Gamma_{opt}]$ represents the mean value of variations of phase angle

of $\Gamma_{opt}$. In accordance with the above discussion, $M^{+}[\Gamma_{opt}]$ and $M^{-}[\Gamma_{opt}]$ are set as follows.

$M^{+}[\Gamma_{opt}] = (0.8, 100^{\circ})$
$M^{-}[\Gamma^{opt}] = (0.6, 100^{\circ})$

The distances from $M^{+}[\Gamma_{opt}]$ and $M^{-}[\Gamma_{opt}]$ to $M[\Gamma_{opt}]$ are $\pm 2\sigma$. Then, the constant noise contours are drawn for $\Gamma_{opt} = M^{+}[\Gamma_{opt}]$ and $\Gamma_{opt} = M^{-}[\Gamma_{opt}]$. If the circle $R_F^{+}$ for $F_{min}$ + a(dB) of the constant noise contours for $\Gamma_{opt} = M^{+}[\Gamma_{opt}]$, and the circle $R_F^{-}$ for $F_{min}$ + a(dB) of the constant noise contours for $\Gamma_{opt} = M^{-}[\Gamma_{opt}]$ cross on the line connecting $M[\Gamma_{opt}]$ and the center of the Smith chart shown in Fig.1, the crosspoint may be used as $\Gamma_Q$ in designing the input matching circuit of the amplifier. Namely, the input matching circuit is designed to convert the impedance from 50Ω to $\Gamma_Q$.

Such an input matching circuit is shown in Fig.5, which may be implemented by an open stub A and a microstrip line B. This is explained with reference to an imittance chart shown in Fig.6. Both the open stub A and the microstrip line B are formed by microstrip lines having a characteristic impedance of 50Ω. The 50Ω point at the center of the Smith chart is converted to a point P by the open stub A. Since a suceptance of the point P is j-1.7, an electrical length $Q_{11}$ of the open stub A may be set to

$$Q_{11} = \tan^{-1} 1.7 = 59.5^{\circ}$$

An electrical length $Q_{12}$ of the microstrip line B may be set to convert the point P to $\Gamma_Q$. A wavelength for the point P is 0.069 when it is read from a wavelength circle on an extended line of a line OP, where O is the center of the chart. Similarly, a wavelength for $\Gamma_Q$ is 0.111. Accordingly, the electrical length $Q_{12}$ of the microstrip line B is given by

$$Q_{12} = 360^{\circ} \times (0.111 + 0.069) = 64.8^{\circ}$$

Accordingly, the open stub A in the input matching circuit may be designed to have the characteristic impedance of 50Ω and the electrical length $Q_{11}$ of 59.5°, and the microstrip line B may be designed to have the characteristic impedance of 50Ω and the electrical length $Q_{12}$ of 64.8°.

In the past, when the input matching circuit is designed, it is designed such that the input matching circuit matches to the mean value of the manufacture variations of $\Gamma_{opt}$. Namely, the input matching circuit is matched to $M[\Gamma_{opt}]$ on the smith chart of Fig.4. However, since the constant noise contours are not concentric as described above, such design does not necessarily minimize the mean value of the variations of the NF of the amplifier caused by the variations of $\Gamma_{opt}$, because the intervals of the constant noise contours are not uniform. In the low noise amplifier which uses the input matching circuit of the present invention, the matching point is shifted toward larger interval of the constant noise contours so that the mean value of variations of the NF of the amplifier caused by the variations of $\Gamma_{opt}$ is minimized.

From the invention thus described, it will be obvious that the invention may be varied in many ways. Such variations are not to be regarded as a departure from the spirit and scope of the invention, and all such modifications as would be obvious to one skilled in the art are intended to be included within the scope of the following claims.

## Claims

1. An input matching circuit adapted to be connected to an input circuit of an amplifier characterized by that a line connecting a point on a Smith chart indicating a mean value of variations of an optimum signal source impedance due to manufacture variations of the amplifier and a center point of the Smith chart is drawn, two points on said line which are spaced from said mean value point by predetermined multiples of a standard deviation of variations of said optimum signal source impedance are determined, a crosspoint of those constant noise contours in two groups of constant noise contours respectively having said two points as the optimum signal source impedances and imparting the same noise index each other on said line is determined, and the signal source impedance as viewed from said amplifier is designed to have the impedance indicated by said crosspoint.

2. An input matching circuit according to Claim 1 wherein said two points determined on said line on said Smith chart are selected form a range of ±1 to ±3 times of the standard deviation spaced from the mean value point of the variations of the optimum signal source impedance.

3. An input matching circuit according to Claim 1 wherein said input matching circuit comprises an open stub and a microstrip, and electrical lengths of said open stub and said microstrip are adjusted to convert impedances so that the signal source impedance as viewed from said amplifier is equal to the impedance determined on the Smith chart.

4. A method for designing an input matching circuit adapted to be connected to an input circuit of an amplifier, characterized by that a line connecting a point on a Smith chart indicating a mean value of variations of an optimum signal source impedance due to manufacture variations of the amplifier and a center point of the Smith chart is drawn, two points on said line which are spaced from said mean value point by predetermined multiples of a standard deviation of variations of said optimum signal source impedance are determined, a crosspoint of those constant noise contours in two groups of constant noise contours respectively having said two points as the optimum signal source impedances and imparting the same noise index on said line is determined, and the signal source impedance as viewed from said low noise amplifier is designed to have the impedance indicated by said crosspoint.

**5.** A method for designing the input matching circuit according to Claim 4 wherein said two points determined on said line on said Smith chart are selected from a range of ±1 to ±3 times of the standard deviation spaced from the mean value point of the variations of the optimum signal source impedance.

**6.** A method for designing the input matching circuit according to Claim 4 wherein said input matching circuit comprises an open stub and a microstrip, and electrical lengths of said open stub and said microstrip are adjusted to convert impedances so that the signal source impedance as viewed from said amplifier is equal to the impedance determined on the Smith chart.

Fig. 1

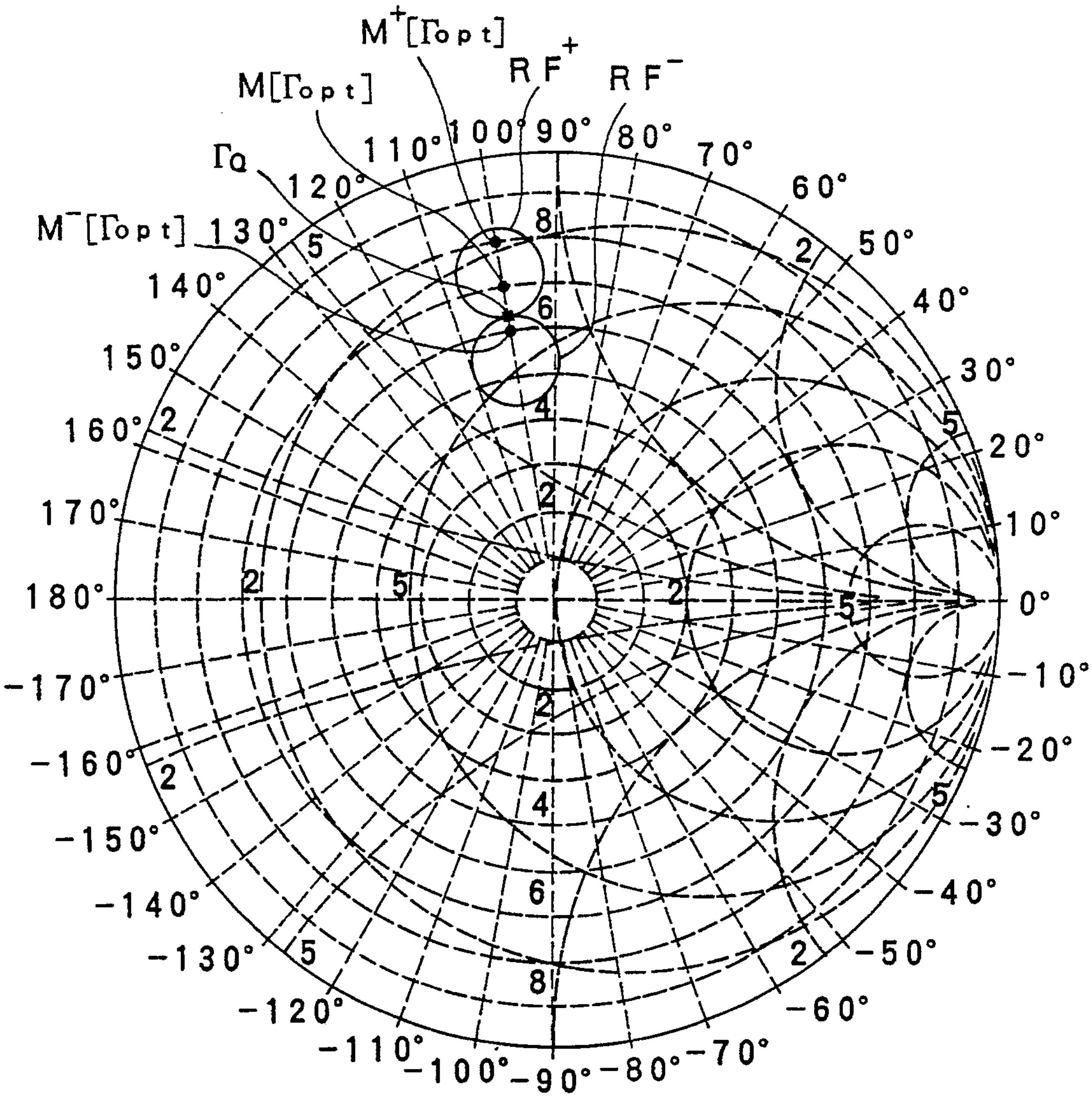
M+[Γopt]
RF+
RF-
M[Γopt]
ΓQ
M-[Γopt]
0°
10°
20°
30°
40°
50°
60°
70°
80°
90°
100°
110°
120°
130°
140°
150°
160°
170°
180°
-10°
-20°
-30°
-40°
-50°
-60°
-70°
-80°
-90°
-100°
-110°
-120°
-130°
-140°
-150°
-160°
-170°

Fig. 2

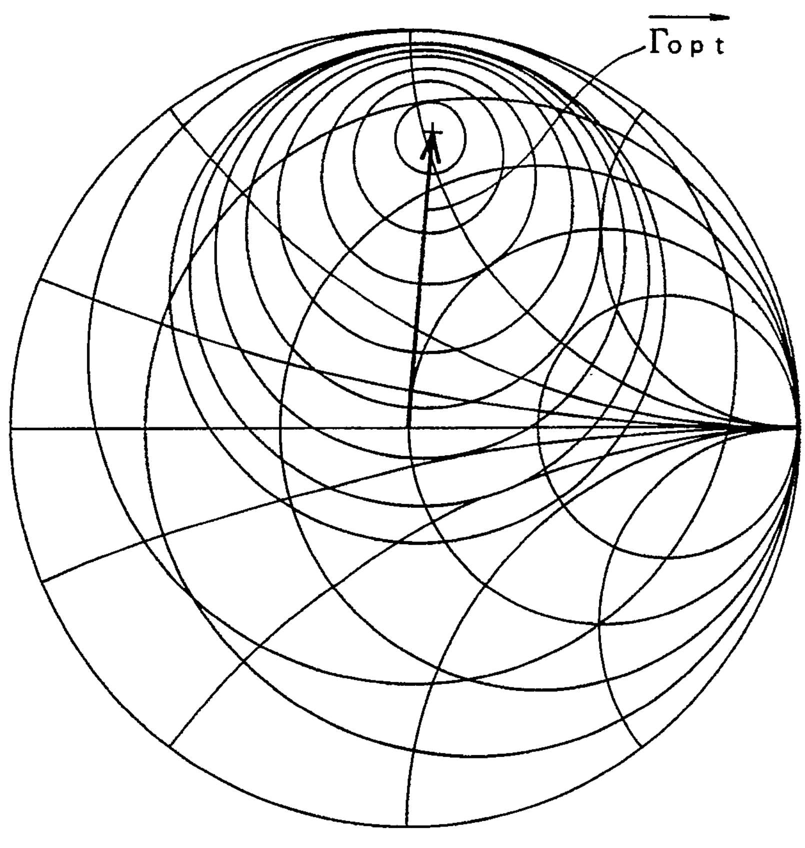

Fig. 3

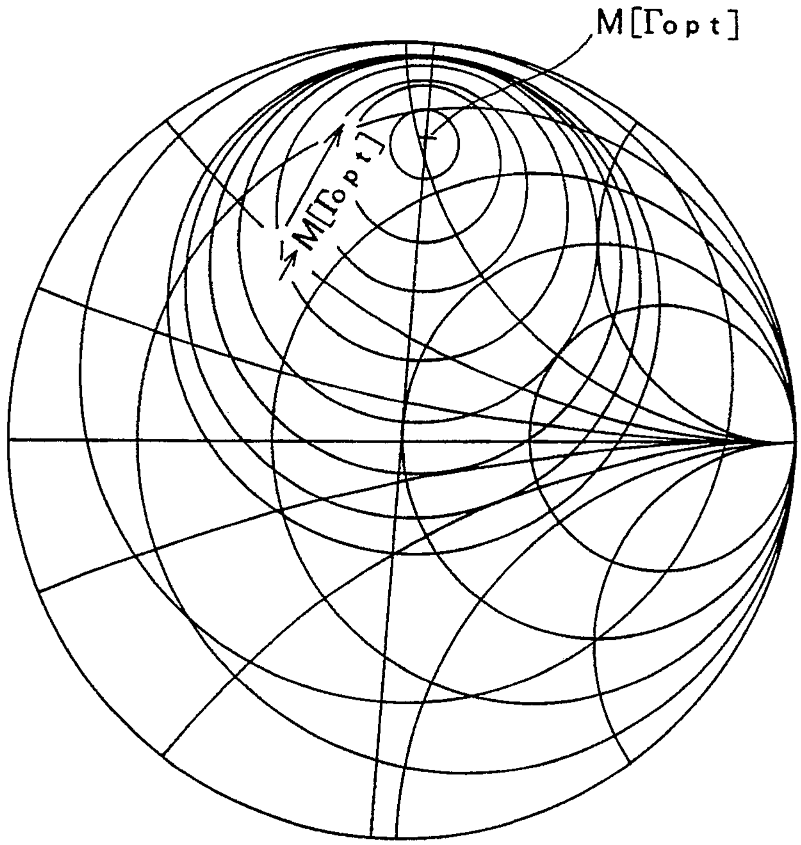

Fig. 4

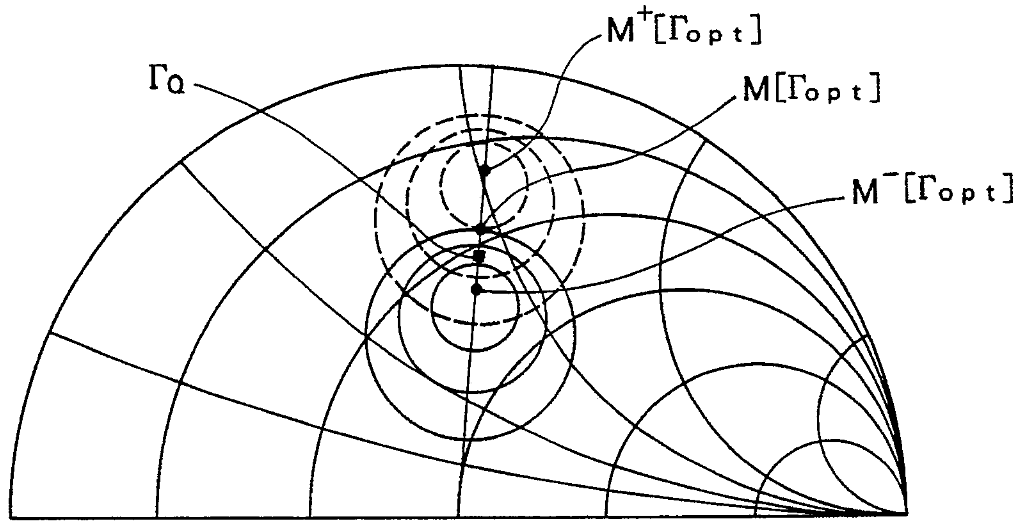

Fig. 5

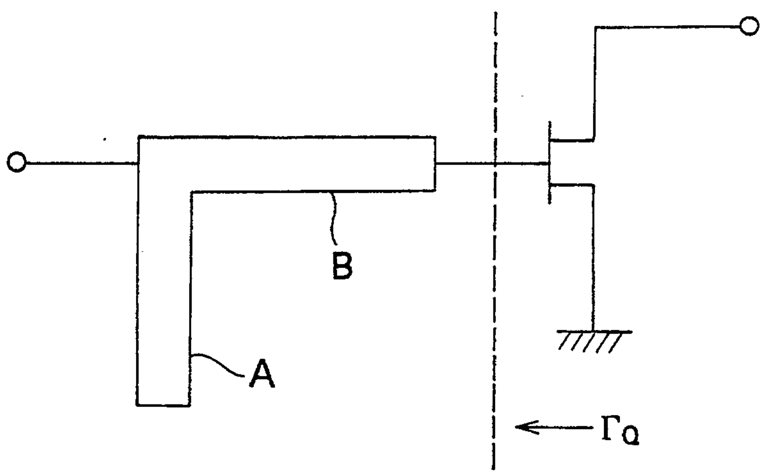

Fig. 6

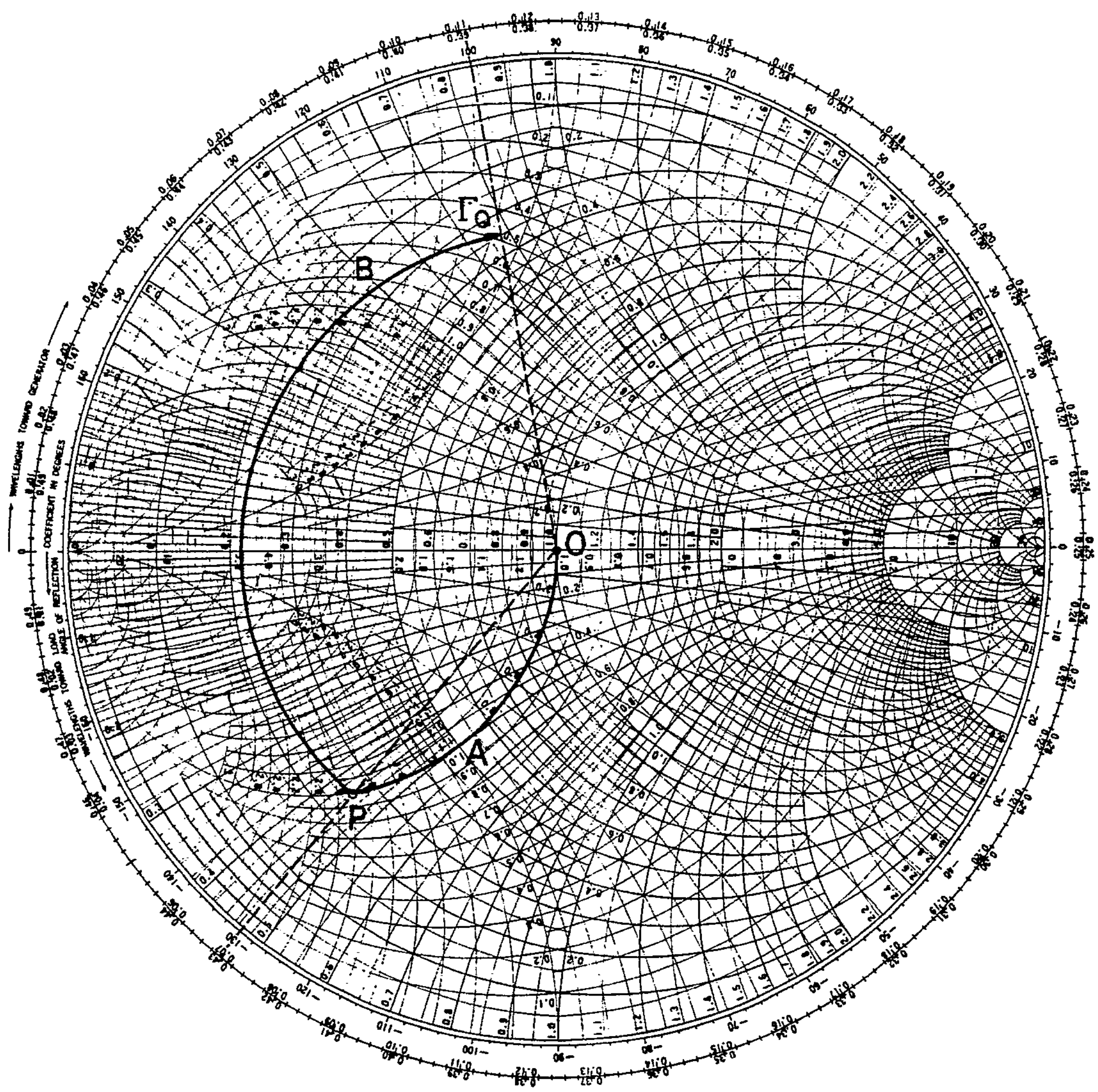

Fig. 7